(19) Europäisches Patentamt / European Patent Office / Office européen des brevets

(11) **EP 4 012 429 B1**

(12) **EUROPEAN PATENT SPECIFICATION**

(45) Date of publication and mention
of the grant of the patent:
**04.12.2024 Bulletin 2024/49**

(21) Application number: **21213890.3**

(22) Date of filing: **10.12.2021**

(51) International Patent Classification (IPC):
**G01R 31/382** (2019.01)    **H02J 7/00** (2006.01)

(52) Cooperative Patent Classification (CPC):
**G01R 31/382; H02J 7/00032; H02J 7/0048;**
H02J 7/00712

(54) **METHOD OF ESTIMATING A STATE-OF-CHARGE OF A BATTERY PACK**

VERFAHREN ZUR SCHÄTZUNG DES LADEZUSTANDES EINES BATTERIEPACKS

PROCÉDÉ D'ESTIMATION D'UN ÉTAT DE CHARGE D'UN BLOC-BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.12.2020 US 202063124355 P**

(43) Date of publication of application:
**15.06.2022 Bulletin 2022/24**

(73) Proprietor: **Techtronic Cordless GP
Anderson, SC 29621 (US)**

(72) Inventor: **BRYAN, Frederick
Greenville 29607 (US)**

(74) Representative: **Novagraaf Group
Chemin de l'Echo 3
1213 Onex / Geneva (CH)**

(56) References cited:
**WO-A1-2020/079474    US-A1- 2017 160 346
US-A1- 2019 312 242    US-B1- 10 283 987**

**Description**

FIELD

The present disclosure relates generally to battery packs. More particularly, the present disclosure relates to method of estimating a state-of-charge of battery packs used, for instance, in power tool applications.

BACKGROUND

Battery packs are commonly used in portable electrical equipment and tools to facilitate their use in environments where no fixed power supply is available. For example, power tools manufacturers often manufacture a universal power pack that is compatible with different types of cordless power tools, such as electric drills, hammers, screwdrivers, impact wrenches, angle grinders, etc. Power requirements can differ from one power tool to the next. For instance, a power requirement associated with a cordless drill can differ compared to a power requirement associated with a work light. Battery packs range in terms of capacity and quality. Some battery packs have different output capacity, depending on the type of tool to which it is connected.
US 2017/160346; WO 2020/079474; US 2019/312242 and US 10,283,987 each represent prior art according to the preamble of claims 1 and 11.

SUMMARY

Aspects and advantages of embodiments of the present disclosure will be set forth in part in the following description, or may be learned from the description, or may be learned through practice of the embodiments.
The invention is defined in claims 1 and 11; preferred embodiments are discussed in the dependent claims.
These and other features, aspects, and advantages of various embodiments will become better understood with reference to the following description and appended claims. The accompanying drawings, which are incorporated in and constitute a part of this specification, illustrate embodiments of the present disclosure and, together with the description, serve to explain the related principles.

BRIEF DESCRIPTION OF THE DRAWINGS

Detailed discussion of embodiments directed to one of ordinary skill in the art are set forth in the specification, which makes reference to the appended figures, in which:

FIG. 1 depicts a schematic of a power tool according to example embodiments of the present disclosure.
FIG. 2 depicts a schematic of a battery pack according to example embodiments of the present disclosure.
FIG. 3 depicts a battery pack electrically coupled to a device according to example embodiments of the present disclosure.
FIG. 4 depicts a flow diagram of a method of estimating a state-of-charge of a battery pack according to example embodiments of the present disclosure.
FIG. 5 depicts a graphical illustration of capacity of a battery pack for various devices according to example embodiments of the present disclosure.
FIG. 6 depicts a flow diagram of a method of operating a power tool according to example embodiments of the present disclosure.

DETAILED DESCRIPTION

Reference now will be made in detail to embodiments, one or more examples of which are illustrated in the drawings. Each example is provided by way of explanation of the embodiments, not limitation of the present disclosure. In fact, it will be apparent to those skilled in the art that various modifications and variations can be made to the embodiments without departing from the scope of the present disclosure. For instance, features illustrated or described as part of one embodiment can be used with another embodiment to yield a still further embodiment. Thus, it is intended that aspects of the present disclosure cover such modifications and variations.
Example aspects of the present disclosure are directed to battery packs and battery powered systems. A battery pack can include one or more cells. The one or more cells can store and/or transfer charge (e.g., as power) to power a device (e.g., power tool, electric vehicle, etc.) that is electrically coupled to the battery pack. In some implementations, the one or more cells can include one or more lithium-ion (Li-ion) cells arranged to output direct current at a voltage rating of the battery pack. The battery pack can further include a battery controller. The battery controller can be configured to estimate a state-of-charge of the one or more battery cells. For instance, the battery controller can include one or more memory devices configured to store a state-of-charge algorithm that can be executed by a processing circuit (e.g., application specific integrated circuit (ASIC), processor, field programmable gate array (FPGA), discrete logic, etc.) of the battery controller to cause the battery controller to estimate a state-of-charge of the one or more battery cells.

Power requirements can differ from one device to the next. For instance, a power requirement for a cordless drill can be greater than a power requirement for a work light (e.g., LED spotlight). As such, a usable capacity of the battery pack when transferring charge to the cordless drill can be different (e.g., less) than a usable capacity of the battery pack when transferring charge to the work light. Furthermore, since a state-of-charge of the battery pack is determined based, at least in part, on the usable capacity of the battery pack, it follows that the state-of-charge estimation of the battery pack when transferring charge to the cordless drill will be different (e.g., less) than the state-of-charge estimation of the battery pack when transferring charge to the work light.

Conventional battery controllers can attempt to estimate state-of-charge of the battery pack by using foreknowledge or measurement of the device electrically coupled to the battery pack. However, these methods are inaccurate due to variations in the power requirement of the devices with which the battery pack is compatible. As such, state-of-charge estimations performed by conventional battery controllers do not account for variations in the power requirement of different devices (e.g., cordless power drill, LED spotlight) that can be electrically coupled to the battery pack.

Example aspects of the present disclosure are directed to a method of determining a state-of-charge of a battery pack. When the battery pack is electrically coupled to a device, the device can provide data to the battery controller. The data can be indicative of a power requirement for the device. For instance, a controller associated with the device can be configured to provide the data (e.g., using one or more data packets) to the battery controller via a communication link. In some implementations, the communication link can include a wired communication link. In alternative implementations, the communication link can include a wireless communication link. It should be understood that the data indicative of the power requirement for the device can be provided as an input to the state-of-charge algorithm executed by the processing circuit of the battery controller.

In some implementations, the data indicative of the power requirement for the device can include data indicative of one or more electrical parameters associated with the device. For instance, the one or more electrical parameters can include a maximum current the device must draw in order to perform an action. In some implementations, the one or more electrical parameters can include a rated current for the device. In some implementations, the one or more electrical parameters can include a maximum power the device must draw in order to perform an action. In some implementations, the one or more electrical parameters can include an impedance (e.g., normal, minimum) of the device. It should be appreciated, however, that the one or more electrical parameters can include any suitable parameters of the device that can be used to determine a power requirement for the device.

In some implementations, the data indicative of the power requirement for the device can include data indicative of a transient current the device initially draws when performing an action. For example, the device can be a cordless power drill, and the action can include drilling a hole or driving a fastener (e.g., screw). In such implementations, the data can be indicative of the transient current (e.g., about 40 Amps) an electric motor of the cordless power drill initially draws such that the cordless power drill can perform the action.

In some implementations, the data indicative of the power requirement for the device can include a current profile for the device. For instance, the current profile can include data indicative of electrical current the device draws with respect to time. In alternative implementations, the data indicative of the power requirement for the device can include a power profile for the device. For instance, the power profile can include data indicative of electrical power the device draws with respect to time.

In the claimed invention, the data indicative of the power requirement for the device includes data indicative of a model number associated with the device. For instance, the device can be a cordless power tool, and the data indicative of the power requirement for the device can include data indicative of a model number associated with the cordless power tool. In such implementations, the battery controller can be configured to store a look-up table or other data structure that includes the model number and power requirement for a plurality of different power tools (e.g., leaf-blower, chainsaw, impact driver, etc.). For instance, the one or more memory devices of the battery controller can be configured to store the look-up table. The battery controller can be configured to match the model number associated with the device electrically coupled to the battery pack to one of the model numbers included in the look-up table. In this manner, the battery controller can determine a power requirement for the device based, at least in part, on the data indicative of the model number associated with the device.

The method according to the present disclosure can include determining a state-of-charge of the one or more battery cells based, at least in part, on the data indicative of the power requirement for the device. For instance, the battery controller of the battery pack can be configured to adjust the state-of-charge of the one or more battery cells from a first state-of-charge to a second state-of-charge based, at least in part, on the data indicative of the power requirement for the device. In this manner, the state-of-charge of the one or more battery cells can be adjusted based, at least in part, on the power requirement for the device electrically coupled to the battery pack.

In some implementations, the method according to the present disclosure can include providing a notification indicative of the determined state-of-charge of the one or more battery cells for display on a display device. For instance, in some implementations, the battery controller can be configured to provide the notification to the device for display on a display device thereof. Alternatively, or additionally, the battery controller can be configured to provide the notification for display on a display device associated with the battery pack. Other methods for providing a notification indicative of the state-of-charge can be used without deviating from the scope of the present disclosure, such as illumination of one or more indicators (e.g., LED indicators) located on the battery pack and/or the device.

Example aspects of the present disclosure can provide for a number of technical effects and benefits. For instance, the battery controller can obtain data indicative the power requirement for the device electrically coupled to the battery controller. Furthermore, the battery controller can determine the state-of-charge of the battery pack based, at least in part, on the power requirement. More specifically, the battery controller can adjust (e.g., increase or decrease) the state-of-charge of the battery pack based, at least in part, on the power requirement. In this manner, information indicative of the state-of-charge of the battery pack can be adjusted as needed based on different power requirements for the various devices (e.g., power tools, LED spotlights, electric vehicles, etc.) that can be electrically coupled to the battery pack.

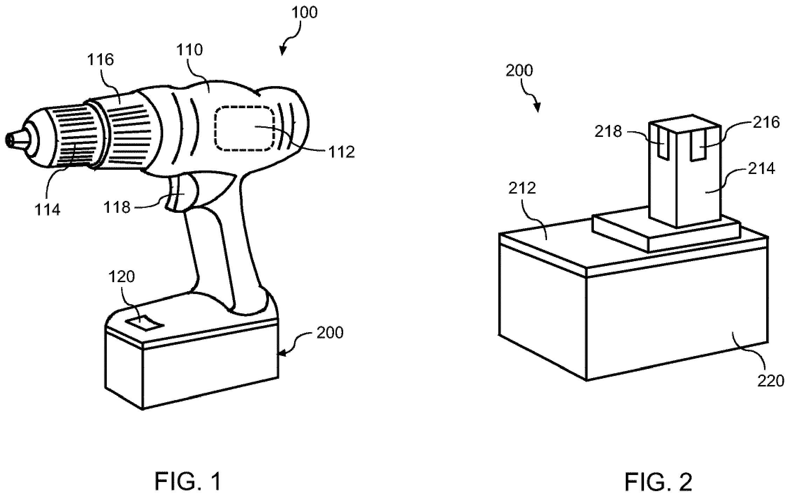

Referring now to FIG. 1, a cordless power tool 100 is provided according to example embodiments of the present disclosure. The cordless power tool 100 includes a housing 110 and an electric motor 112 (denoted in dashed lines) disposed within the housing 110. The electric motor 112 can be electrically coupled to a battery pack 200 that is removably coupled to housing 110 of the cordless power tool 100. In this manner, the electric motor 112 can receive electrical energy from the battery pack 200. The electric motor 112 can be configured to convert the electrical energy into mechanical energy needed to drive rotation of an object (e.g., drill bit, fastener) retained by a chuck 114 of the cordless power tool 100. In some implementations, the cordless power tool 100 can include a clutch 116. The clutch 116 can be configured to adjust an amount of torque that is delivered to the object. As shown, the cordless power tool 100 can include an input device 118 configured to receive a user-input associated with controlling operation of the electric motor 112. For instance, the input device 118 can include a trigger that a user can pull to provide user-input associated with actuating the electric motor 112 to perform an action (e.g., drill a hole, drive a fastener, etc.).

In some implementations, the cordless power tool 100 can include a display device 120. The display device 120 can be configured to display information associated with operation of the battery pack 200. For instance, in some implementations, the display device 120 can display information indicative of a state-of-charge of the battery pack 200. In this manner, a user can determine the state-of-charge of the battery pack by viewing the information displayed on the display device 120 of the cordless power tool 100.

Referring now to FIG. 2, the battery pack 200 is provided according to example embodiments of the present disclosure. As shown, the battery pack 200 can include a battery housing 210. The battery housing 210 can be configured to accommodate one or more battery cells (not shown). The one or more cells can be configured to store and/or transfer charge (e.g., as power) to power the cordless power tool 100 (FIG. 1). For instance, the battery housing 210 can include a terminal post 214 having terminals 216, 218. It should be understood that the one or more battery cells can be electrically coupled to the electric motor 112 when the battery housing 210 is removably coupled to the cordless power tool 100.

FIGS. 1 and 2 depict one example of a power tool and battery pack for purposes of illustration and discussion. Those of ordinary skill in the art, using the disclosures provided herein, will understand that a battery pack can be used to deliver power to devices other than cordless power tools (e.g., drills, leaf blowers, etc.). For instance, in some implementations, the battery pack 200 can be used to deliver power to a light emitting diode (LED) spotlight.

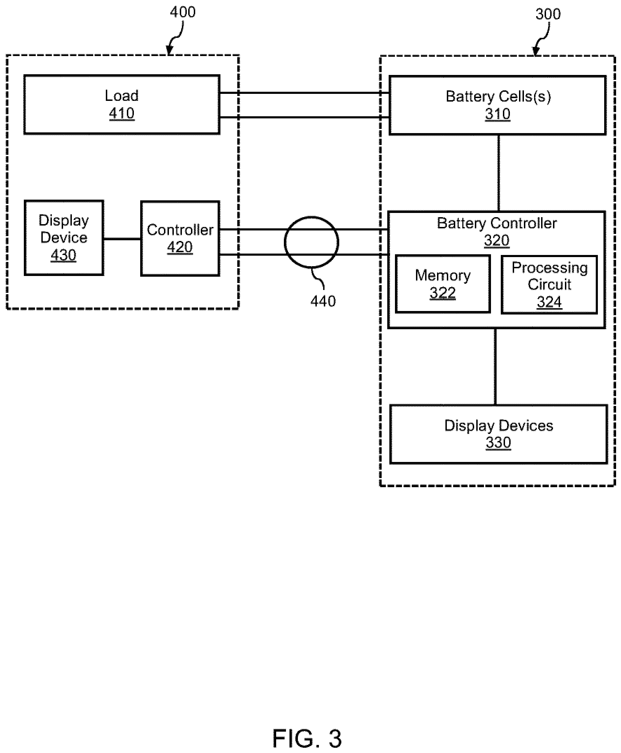

Referring now to FIG. 3, a battery pack 300 electrically coupled to a device 400 is provided according to example embodiments. In this manner, the battery pack 300 can deliver electrical power to the device 400, specifically a load 410 thereof. In some implementations, the device 400 can be a cordless power tool, such as the cordless power tool 100 discussed above with reference to FIG. 1. However, it should be understood that the device 400 can include any device having one or more loads configured to receive electrical power from the battery pack 300. For instance, in some implementations, the device 400 can be an electric vehicle. In alternative implementations, the device 400 can include a light emitting diode (LED) spotlight.

As shown, the battery pack 300 can include one or more battery cells 310. The one or more battery cells 310 can be configured to store and/or transfer charge (e.g., as power) to the device 400 via one or more conductors 312. In some implementations, the load 410 of the device 400 can be an electric motor. In alternative implementations, the load 410 can be a power supply. For instance, the power supply can be a DC/DC power supply for one or more light sources (e.g., LEDs). Alternatively, the power supply can be a DC/DC power supply for a USB output associated with the device 400. In some implementations, the load 410 can be a passive electrical component (e.g., resistor).

The battery pack 300 can include a battery controller 320. The battery controller 320 can be configured to estimate a state-of-charge of the one or more battery cells 310. For instance, the battery controller 320 can include one or more memory devices 322 configured to store a state-of-charge algorithm that can be executed by a processing circuit 324 of the battery controller 320 to cause the battery controller 320 to estimate a state-of-charge of the one or more battery cells 310. In some implementations, the processing circuit 324 can include one or more processors. In alternative implementations, the processing circuit 324 can include a field programmable gate array (FPGA) or other discrete logic circuit. As will be discussed below in more detail, the battery controller 320 can be configured to obtain information from the device 400 that allows the battery controller 320 to estimate the state-of-charge of the one or more battery cells 310.

When the battery pack 300 is electrically coupled to the device 400, the device 400 can provide data to the battery controller 320. The data can be indicative of a power requirement for the device 400. For instance, a controller 420 associated with the device 400 can be configured to provide the data to the battery controller 320 via a communication link 440. In some implementations, the communication link 440 can include a wired communication link (e.g., one or more pins or terminals). In alternative implementations, the communication link 440 can include a wireless communication link. It should be understood that the data indicative of the power requirement associated with the device 400 can be provided as an input to the state-of-charge algorithm executed by the processing circuit 324 of the battery controller 320.

In some implementations, the data indicative of the power requirement for the device 400 can include data indicative of one or more electrical parameters associated with the device 400. For instance, the one or more electrical parameters can include a maximum current the device 400 must draw in order to perform an action. In some implementations, the one or more electrical parameters can include a rated current for the device 400. In some implementations, the one or more electrical parameters can include a maximum power the device 400 must draw in order to perform an action. In some implementations, the one or more electrical parameters can include an impedance (e.g., normal, minimum) of the device 400. It should be appreciated, however, that the one or more electrical parameters can include any suitable parameters of the device that can be used to determine a power requirement for the device 400.

In some implementations, the data indicative of the power requirement associated with the device 400 can include data indicative of a transient current the device 400 initially draws when performing an action. For example, the device 400 can be the cordless power tool 100 discussed above with reference to FIG. 1, and the action can include drilling a hole or driving a fastener (e.g., screw). In such implementations, the data can be indicative of the transient current (e.g., about 40 Amps) the cordless power tool 100 initially draws when performing the action.

In some implementations, the data indicative of the power requirement for the device 400 can include a current profile for the device 400. For instance, the current profile can include data indicative of electrical current the device 400 draws with respect to time. In alternative implementations, the data indicative of the power requirement for the device 400 can include a power profile for the device 400. For instance, the power profile can include data indicative of electrical power the device 400 draws with respect to time.

In the invention, the data indicative of the power requirement includes data indicative of a model number associated with the device 400. For instance, the device 400 can be the cordless power tool 100 discussed above with reference to FIG. 1, and the data indicative of the power requirement can include data indicative of a model number associated with the cordless power tool 100. In such implementations, the battery controller 320 can be configured to store a look-up table that includes the model number and power requirement for a plurality of different power tools (e.g., leaf-blower, chainsaw, impact driver, etc.). For instance, the one or more memory devices of the battery controller 320 can be configured to store the look-up table. The battery controller 320 can be configured to match the model number associated with the device 400 to one of the model numbers included in the look-up table. In this manner, the battery controller 320 can determine a power requirement for the cordless power tool 100 based, at least in part, on the data indicative of the model number associated with the cordless power tool 100.

The battery controller 320 can be configured to determine a state-of-charge of the one or more battery cells 310 based, at least in part, on the data indicative of the power requirement for the device 400. For instance, the battery controller 320 can be configured to adjust the state-of-charge of the one or more battery cells 310 from a first state-of-charge to a second state-of-charge based, at least in part, on the data indicative of the power requirement for the device 400. In this manner, the state-of-charge of the one or more battery cells 310 can be adjusted based, at least in part, on the power requirement of the device 400 electrically coupled to the battery pack 300.

The battery controller 320 can be configured to provide a notification indicative of the determined state-of-charge of the one or more battery cells 310 for display on a display device. For instance, in some implementations, the battery controller 320 can be configured to provide the notification to the device 400 via the communication link 440 for display on a display device 430 associated with the device 400. Alternatively, or additionally, the battery controller 320 can be configured to provide the notification for display on a display device 330 associated with the battery pack 300.

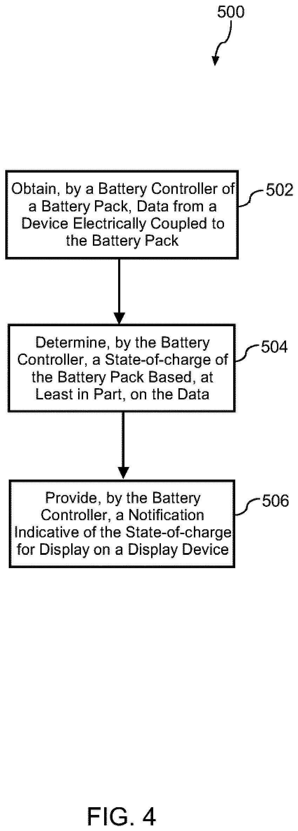

Referring now to FIG. 4, a flow chart of an example method 500 of estimating a state-of-charge of a battery pack is provided according to example embodiments of the present disclosure. It should be appreciated that the method 500 can be implemented by the battery controller 320 discussed above with reference to FIG. 3. Furthermore, although FIG. 4 depicts steps performed in a particular order for purposes of illustration and discussion, the methods of the present disclosure are not limited to the particularly illustrated order or arrangement. It should be understood that the various steps of the method 500 can be omitted, rearranged, combined, and/or adapted in various ways without deviating from the scope of the present disclosure.

At (502), the method 500 includes obtaining, by a battery controller of a battery pack, data from a device electrically coupled to the battery pack. The data can be indicative of a power requirement for the device. Furthermore, the device can be configured to provide the data indicative of the power requirement to the battery controller via a wired or wireless communication link.

In some implementations, the data indicative of the power requirement for the device can include data indicative of one or more electrical parameters associated with the device. For instance, the one or more electrical parameters can include a maximum current the device must draw in order to perform an action. In some implementations, the one or more electrical parameters can include a rated current for the device. In some implementations, the one or more electrical parameters can include a maximum power the device must draw in order to perform an action. In some implementations, the one or more electrical parameters can include an impedance (e.g., normal, minimum) of the device. It should be appreciated, however, that the one or more electrical parameters can include any suitable parameters that can be used to determine a power requirement for the device.

In some implementations, the data indicative of the power requirement for the device can include data indicative of a transient current the device initially draws when performing an action. For example, the device can be a cordless power drill, and the action can include drilling a hole or driving a fastener (e.g., screw). In such implementations, the data can be indicative of the transient current (e.g., about 40 Amps) the cordless power drill initially draws when performing the action.

In some implementations, the data indicative of the power requirement for the device can include a current profile for the device. For instance, the current profile can include data indicative of electrical current the device draws with respect to time. In alternative implementations, the data indicative of the power requirement for the device can include a power profile for the device. For instance, the power profile can include data indicative of electrical power the device draws with respect to time.

In the invention, the data indicative of the power requirement includes data indicative of a model number associated with the device. For instance, the device can be a cordless power tool, and the data indicative of the power requirement can include data indicative of a model number associated with the cordless power tool. In such implementations, the battery controller can be configured to store a look-up table that includes the model number and power requirement for a plurality of different power tools (e.g., leaf-blower, chainsaw, impact driver, etc.). For instance, the one or more memory devices of the battery controller can be configured to store the look-up table. The battery controller can be configured to match the model number associated with the device to one of the model numbers included in the look-up table. In this manner, the battery controller can determine a power requirement for the device based, at least in part, on the data indicative of the model number associated with the device.

At (504), the method 500 includes determining, by the battery controller, a state-of-charge of the battery pack based, at least in part, on the data indicative of the power requirement. For instance, in some implementations, determining the state-of-charge of the battery pack can include adjusting the state-of-charge of the battery pack from a first state-of-charge to a second state-of-charge. The second state-of-charge can be lower than the first state-of-charge when a second device electrically coupled to the battery pack has a higher power requirement compared to a first device that was electrically coupled to the battery pack immediately before the second device.

At (506), the method 500 includes providing, by the battery controller, a notification indicative of the state-of-charge determined at (504) for display on a display device. For instance, in some implementations, the display device can be associated with the device. Alternatively, or additionally, the display device can be associated with the battery pack. In this manner, a user associated with the device and/or the battery pack can view the notification indicative of the state-of-charge.

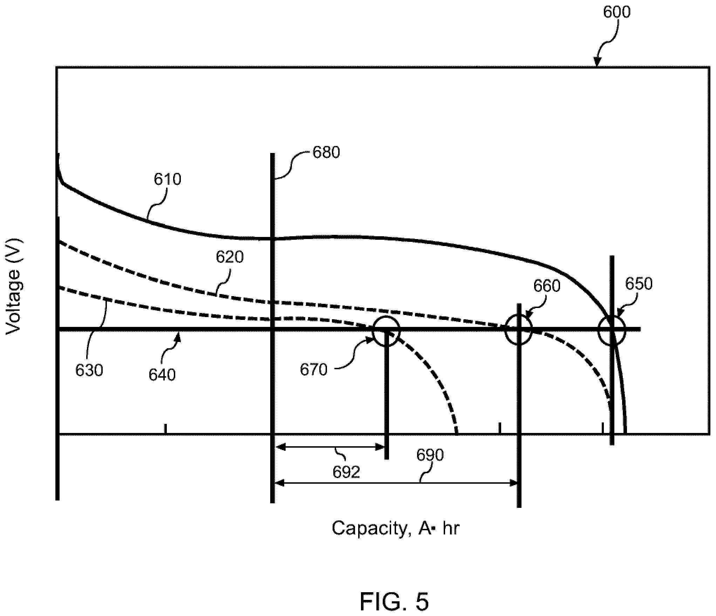

Referring now to FIG. 5, a graphical illustrations of how usable capacity of a battery pack or battery-powered system differs for devices with different power requirements is provided according to example embodiments of the present disclosure. As shown, graph 600 depicts curves 610, 620, and 630, which each correspond to voltage (denoted along the vertical axis in volts) as a function of capacity (denoted along horizontal axis in amp-hours) of the battery pack. Curve 610 corresponds to the open circuit voltage of the battery pack - that is the voltage of the pack or cells at any SOC if no device or a device having a low power requirement is applied to the cell(s). Curve 620 corresponds to the external battery voltage of the battery pack when the battery pack is electrically coupled to a first device having a first power requirement. Curve 630 corresponds to the external battery voltage of the battery pack when the battery pack is electrically coupled to a second device having a second power requirement that is different than the first power requirement. For instance, the second power requirement associated with the second device can be different (e.g., greater) than the first power requirement associated with the first device. More particularly, an initial current drawn by the second device can be greater than an initial current drawn by the first device. In this manner, a voltage drop across the battery pack when coupled to the second device is greater than a voltage drop across the battery pack when coupled to the first device.

As shown, curve 630 intersects line 640, which corresponds to the shutdown voltage of the battery pack or battery-powered system, before curve 620 intersects line 640. It should be appreciated that the point at which curves 610, 620, and 630 intersect line 640 corresponds to a usable capacity (Quse) of the battery pack when coupled to a device having a low power requirement, a first device having a first power requirement, and a second device having a second power requirement, respectively. For instance, the battery pack has a maximum capacity 650 when coupled to a device having a low power requirement. Then it has a lesser usable capacity 660 when coupled to the first device, and an even lesser usable capacity 670 when coupled to the second device. This is due, in part, to the first power requirement of the first device being greater than the low power power requirement, and the second power requirement (e.g., initial current) of the second device being greater than the first power requirement (e.g., initial current) of the first device.

An amount of charge (e.g., Qpass) that has already been depleted (i.e., transferred from battery pack to device) is indicated by line 680 in the graph 600. It should be understood that line 680 will move to the right (e.g., closer to usable capacity) as the battery pack or battery powered system continues to transfer charge to the device. It should also be understood that a state-of-charge (SOC) of the battery pack can be determined using the below formula:

$$SOC = \frac{Quse - Qpas}{Quse}$$ Equation 1

In the above formula, $Q_{pass}$ corresponds to the amount of charge that has already been depleted. Additionally, $Q_{use}$ corresponds to the usable capacity of the battery pack. As shown in the graph 600, a difference 690 (e.g., delta) between line 680 and the usable capacity 660 of the first device is greater than a difference 692 (e.g., delta) between line 680 and the usable capacity 670 of the second device. As such, the SOC of the battery pack or battery powered system when coupled to the first device is greater than the SOC of the battery pack or battery powered system when coupled to the second device. This is due, in part, to the first power requirement (e.g., initial current) associated with the first device being lower than the second power requirement (e.g., initial current) associated with the second device.

As discussed above, the battery controller of the battery pack according to the present disclosure can be configured to adjust the state-of-charge of the battery pack to account for variations in the power requirement of the different devices that can be coupled to the battery pack. In this manner, the state-of-charge of the battery pack determined by the battery controller according to the present disclosure can be specific to the device that is currently coupled to the battery pack.

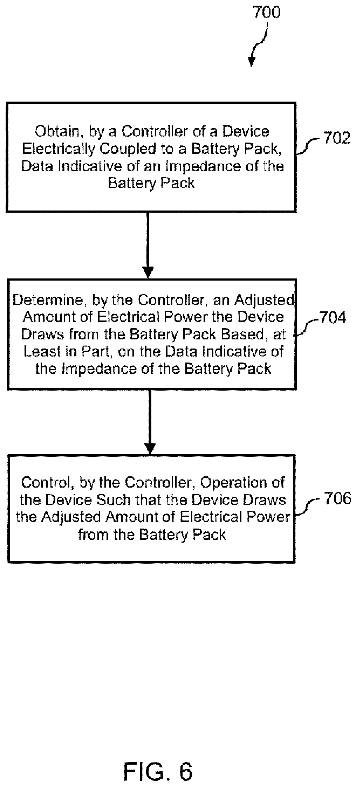

Referring now to FIG. 6, a flow chart of a method 700 of controlling operation of a device electrically coupled to a battery pack is provided according to example embodiments of the present disclosure. It should be appreciated that the method 700 can be implemented by the controller 420 of the device 400 discussed above with reference to FIG. 3. Furthermore, although FIG. 6 depicts steps performed in a particular order for purposes of illustration and discussion, the methods of the present disclosure are not limited to the particularly illustrated order or arrangement. It should be understood that the various steps of the method 700 can be omitted, rearranged, combined, and/or adapted in various ways without deviating from the scope of the present disclosure.

At (702), the method 700 can include obtaining, by a controller of the device, data from the battery pack electrically coupled to the device. The data can be indicative of an impedance of the battery pack. In some implementations, a battery controller of the battery pack can provide the data (e.g., impedance) to the device via a wired communication link. In alternative implementations, the battery controller can provide the data to the device via a wireless communication link.

At (704), the method 700 can include determining, by the controller of the device, an adjustment to a maximum amount of electrical power the device draws from the battery pack based, at least in part, on the data obtained at (702). For instance, determining an adjustment to the maximum amount of electrical power an electric motor of the device draws from the battery pack can include adjusting, by the battery controller, an electric current the electric motor draws from the battery pack. More particularly, the electric current the electric motor draws from the battery pack can be reduced when the data obtained at (702) indicates the impedance of the battery pack is below a threshold value. At (706), the method 700 can include controlling, by the controller of the device, operation of the device such that the device draws the adjusted amount of electrical power.

While the present subject matter has been described in detail with respect to specific example embodiments thereof, it will be appreciated that those skilled in the art, upon attaining an understanding of the foregoing may readily produce alterations to, variations of, and equivalents to such embodiments. Accordingly, the scope of the present disclosure is by way of example rather than by way of limitation, and the subject disclosure does not preclude inclusion of such modifications, variations and/or additions to the present subject matter as would be readily apparent to one of ordinary skill in the art. The scope of the invention is defined by the claims.

**Claims**

1. A method of estimating a state-of-charge of a battery pack (200, 300) comprising a plurality of cells (310), the method comprising:

   obtaining, by a battery controller (320) of the battery pack (200, 300), data from a power tool (100) electrically coupled to the battery pack (200, 300), the data indicative of a power requirement for the power tool (100); and determining, by the battery controller (320), a state-of-charge of the battery pack (200, 300) based, at least in part, on the data indicative of the power requirement for the power tool (100) which comprises adjusting, by the battery controller (320), the state-of-charge of the battery pack (200, 300) from a first state-of-charge to a second state-of-charge based, at least in part, on the data indicative of the power requirement for the power tool (100), **characterized in that** :
   obtaining data indicative of a power requirement for the power tool (100) comprises obtaining, by the battery controller (320), data indicative of a model number assigned to the power tool (100).

2. The method of claim 1, wherein the second state-of-charge is less than the first state-of-charge.

3. The method of any of claims 1 through 2, wherein the data indicative of the power requirement for the power tool (100) comprises data indicative of one or more electrical parameters of the power tool (100).

4. The method of claim 3, wherein the data indicative of the one or more electrical parameters comprise a maximum current for the power tool (100), a maximum power for the power tool (100), an impedance of the power tool (100), or a rated current for the power tool (100).

5. The method of claim 1, wherein obtaining data indicative of a power requirement for the power tool (100) comprises obtaining, by the battery controller (320), data indicative of the amount of electrical power an electric motor of the power tool (100) needs to draw to perform an action.

6. The method of claim 5, wherein the power tool (100) comprises a cordless drill; and
   the action comprises drilling a hole or driving a fastener.

7. The method of any of claims 5 through 6, wherein obtaining data indicative of a power requirement for the power tool (100) comprises obtaining, by the battery controller (320), data indicative of a current an electric motor of the power tool (100) needs to draw to perform an action.

8. The method of claim 1, wherein determining the state-of-charge of the battery pack (200, 300) comprises:
   matching the model number assigned to the power tool (100) to one of a plurality of model numbers included in a look-up table stored in one or more memory power tools (100) of the battery pack (200, 300), the look-up table including a power requirement for each of the plurality of model numbers.

9. The method of any of claims 1 through 8, further comprising:
   providing, by the battery controller (320), a notification indicative of the state-of-charge for display on a display power tool (100).

10. The method of claim 9, wherein the display power tool (100) is associated with the battery pack (200, 300).

11. A battery pack (200, 300) comprising:

    one or more battery cells; and
    a controller configured to perform operations, the operations comprising:
    obtaining data from a power tool (100) electrically coupled to the one or more battery cells, the data indicative of a power requirement for the power tool (100); and
    determining a state-of-charge of the battery pack (200, 300) based, at least in part, on the data indicative of the power requirement for the power tool (100) which comprises adjusting, by the battery controller (320), the state-of-charge of the battery pack (200, 300) from a first state-of-charge to a second state-of-charge based, at least in part, on the data indicative of the power requirement for the power tool (100),
    **characterized in that** :
    obtaining data indicative of a power requirement for the power tool (100) comprises obtaining, by the battery controller, data indicative of a model number assigned to the power tool (100).


**Patentansprüche**

1. Verfahren zum Schätzen eines Ladezustands eines Akkupacks (200, 300), umfassend eine Vielzahl von Zellen (310), das Verfahren umfassend:

   Erhalten, durch eine Akkusteuerung (320) des Akkupacks (200, 300), von Daten von einem Elektrowerkzeug (100), das mit dem Akkupack (200, 300) elektrisch gekoppelt ist, wobei die Daten einen Leistungsbedarf für das Elektrowerkzeug (100) angeben; und
   Bestimmen, durch die Akkusteuerung (320), eines Ladezustands des Akkupacks (200, 300) basierend mindestens teilweise auf den Daten, die den Leistungsbedarf für das Elektrowerkzeug (100) angeben, was ein Anpassen, durch die Akkusteuerung (320), des Ladezustands des Akkupacks (200, 300) von einem ersten Ladezustand auf einen zweiten Ladezustand mindestens teilweise basierend auf den Daten umfasst, die den Leistungsbedarf für das Elektrowerkzeug (100) angeben,
   **dadurch gekennzeichnet, dass:**
   das Erhalten von Daten, die einen Leistungsbedarf für das Elektrowerkzeug (100) angeben, das Erhalten, durch die Akkusteuerung (320) von Daten umfasst, die eine Modellnummer angeben, die dem Elektrowerkzeug (100) zugewiesen ist.

2. Verfahren nach Anspruch 1, wobei der zweite Ladezustand geringer als der erste Ladezustand ist.

3. Verfahren nach einem der Ansprüche 1 bis 2, wobei die Daten, die den Leistungsbedarf für das Elektrowerkzeug (100) angeben, Daten umfassen, die einen oder mehrere elektrische Parameter des Elektrowerkzeugs (100) angeben.

4. Verfahren nach Anspruch 3, wobei die Daten, die den einen oder die mehreren elektrischen Parameter angeben, einen Maximalstrom für das Elektrowerkzeug (100), eine Maximalleistung für das Elektrowerkzeug (100), eine Impedanz des Elektrowerkzeugs (100) oder einen Nennstrom für das Elektrowerkzeug (100) umfassen.

5. Verfahren nach Anspruch 1, wobei das Erhalten von Daten, die einen Leistungsbedarf für das Elektrowerkzeug (100) angeben, das Erhalten, durch die Akkusteuerung (320), von Daten umfasst, die die Menge an elektrischer Leistung angeben, die ein elektrischer Motor des Elektrowerkzeugs (100) ziehen muss, um eine Aktion durchzuführen.

6. Verfahren nach Anspruch 5, wobei das Elektrowerkzeug (100) einen Akkubohrer umfasst; und
   die Aktion ein Bohren eines Lochs oder ein Eintreiben eines Befestigungselements umfasst.

7. Verfahren nach einem der Ansprüche 5 bis 6, wobei das Erhalten von Daten, die einen Leistungsbedarf für das Elektrowerkzeug (100) angeben, das Erhalten, durch die Akkusteuerung (320), von Daten umfasst, die einen Strom angeben, den ein elektrischer Motor des Elektrowerkzeugs (100) ziehen muss, um eine Aktion durchzuführen.

8. Verfahren nach Anspruch 1, wobei das Bestimmen des Ladezustands des Akkupacks (200, 300) umfasst:
   Abgleichen der Modellnummer, die dem Elektrowerkzeug (100) zugewiesen ist, mit einer von einer Vielzahl von Modellnummern, die in einer Nachschlagetabelle eingeschlossen sind, die in einem oder mehreren Speicherelektrowerkzeugen (100) des Akkupacks (200, 300) gespeichert ist, wobei die Nachschlagetabelle einen Leistungsbedarf für jede der Vielzahl von Modellnummern einschließt.

9. Verfahren nach einem der Ansprüche 1 bis 8, ferner umfassend:
   Bereitstellen, durch die Akkusteuerung (320), einer Benachrichtigung, die den Ladezustand angibt, für eine Anzeige auf einem Anzeigeelektrowerkzeug (100).

10. Verfahren nach Anspruch 9, wobei das Anzeigeelektrowerkzeug (100) mit dem Akkupack (200, 300) verknüpft ist.

11. Akkupack (200, 300), umfassend:

    eine oder mehrere Akkuzellen; und

eine Steuerung, die konfiguriert ist, um Abläufe durchzuführen, die Abläufe umfassend:

Erhalten von Daten von einem Elektrowerkzeug (100), das mit der einen oder den mehreren Akkuzellen elektrisch gekoppelt ist, wobei die Daten einen Leistungsbedarf für das Elektrowerkzeug (100) angeben; und Bestimmen, eines Ladezustands des Akkupacks (200, 300) mindestens teilweise basierend auf den Daten, die den Leistungsbedarf für das Elektrowerkzeug (100) angeben, was ein Anpassen, durch die Akkusteuerung (320), des Ladezustands des Akkupacks (200, 300) von einem ersten Ladezustand auf einen zweiten Ladezustand mindestens teilweise basierend auf den Daten umfasst, die den Leistungsbedarf für das Elektrowerkzeug (100) angeben,

**dadurch gekennzeichnet, dass:**
das Erhalten von Daten, die einen Leistungsbedarf für das Elektrowerkzeug (100) angeben, das Erhalten, durch die Akkusteuerung von Daten umfasst, die eine Modellnummer angeben, die dem Elektrowerkzeug (100) zugewiesen ist.

**Revendications**

1. Procédé d'estimation de l'état de charge d'un bloc-batterie (200, 300) comprenant une pluralité de cellules (310), le procédé comprenant :

l'obtention, par un régulateur de batterie (320) du bloc-batterie (200, 300), des données d'un outil électrique (100) couplé électriquement au bloc-batterie (200, 300), les données indiquant un besoin de puissance pour l'outil électrique (100) ; et
la détermination, par le régulateur de batterie (320), d'un état de charge du bloc-batterie (200, 300) sur la base, au moins en partie, des données indiquant la puissance requise pour l'outil électrique (100), ce qui comprend l'ajustement, par le régulateur de batterie (320), de l'état de charge du bloc-batterie (200, 300) d'un premier état de charge à un second état de charge sur la base, au moins en partie, des données indiquant la puissance requise pour l'outil électrique (100),
**caractérisé en ce que** :
l'obtention de données indiquant une puissance requise pour l'outil électrique (100) comprend l'obtention, par le régulateur de batterie (320), de données indiquant un numéro de modèle attribué à l'outil électrique (100).

2. Procédé selon la revendication 1, dans lequel le second état de charge est inférieur au premier état de charge.

3. Procédé selon l'une quelconque des revendications 1 à 2, dans lequel les données indiquant la puissance requise pour l'outil électrique (100) comprennent des données indiquant un ou plusieurs paramètres électriques de l'outil électrique (100).

4. Procédé selon la revendication 3, dans lequel les données indiquant un ou plusieurs paramètres électriques comprennent un courant maximal pour l'outil électrique (100), une puissance maximale pour l'outil électrique (100), une impédance de l'outil électrique (100), ou un courant nominal pour l'outil électrique (100).

5. Procédé selon la revendication 1, dans lequel l'obtention de données indiquant un besoin de puissance pour l'outil électrique (100) comprend l'obtention, par le régulateur de batterie (320), de données indiquant la quantité de puissance électrique qu'un moteur électrique de l'outil électrique (100) doit tirer pour effectuer une action.

6. Procédé selon la revendication 5, dans lequel l'outil électrique (100) comprend une perceuse sans fil ; et
l'action consiste à percer un trou ou à enfoncer un élément de fixation.

7. Procédé selon l'une quelconque des revendications 5 ou 6, dans lequel l'obtention de données indiquant un besoin de puissance pour l'outil électrique (100) comprend l'obtention, par le régulateur de batterie (320), de données indiquant un courant qu'un moteur électrique de l'outil électrique (100) doit tirer pour effectuer une action.

8. Procédé selon la revendication 1, dans lequel la détermination de l'état de charge du bloc-batterie (200, 300) comprend :
la mise en correspondance du numéro de modèle attribué à l'outil électrique (100) avec l'un d'une pluralité de numéros de modèle inclus dans une table de recherche stockée dans un ou plusieurs outils électriques à mémoire (100) du bloc-batterie (200, 300), la table de recherche comportant une puissance requise pour chacun de la pluralité de numéros de modèle.

9. Procédé selon l'une quelconque des revendications 1 ou 8, comprenant en outre :
la fourniture, par le régulateur de batterie (320), d'une notification indiquant l'état de charge pour affichage sur un outil électrique d'affichage (100).

10. Procédé selon la revendication 9, dans lequel l'outil électrique d'affichage (100) est associé au bloc-batterie (200, 300).

11. Bloc-batterie (200, 300) comprenant :

un ou plusieurs éléments de batterie ; et
un dispositif de commande configuré pour effectuer des opérations, les opérations comprenant :

l'obtention de données d'un outil électrique (100) couplé électriquement à un ou plusieurs éléments de batterie, les données indiquant un besoin de puissance pour l'outil électrique (100) ; et
la détermination d'un état de charge du bloc-batterie (200, 300) sur la base, au moins en partie, des données indiquant la puissance requise pour l'outil électrique (100), ce qui comprend l'ajustement, par le régulateur de batterie (320), de l'état de charge du bloc-batterie (200, 300) d'un premier état de charge à un second état de charge sur la base, au moins en partie, des données indiquant la puissance requise pour l'outil électrique (100),
**caractérisé en ce que** :
l'obtention de données indiquant une puissance requise pour l'outil électrique (100) comprend l'obtention, par le régulateur de batterie, de données indiquant un numéro de modèle attribué à l'outil électrique (100).

FIG. 2

FIG. 1

FIG. 3

500

Obtain, by a Battery Controller of a Battery Pack, Data from a Device Electrically Coupled to the Battery Pack —502

Determine, by the Battery Controller, a State-of-charge of the Battery Pack Based, at Least in Part, on the Data —504

Provide, by the Battery Controller, a Notification Indicative of the State-of-charge for Display on a Display Device —506

FIG. 4

FIG. 5

700

Obtain, by a Controller of a Device
Electrically Coupled to a Battery Pack,
Data Indicative of an Impedance of the
Battery Pack

702

Determine, by the Controller, an Adjusted
Amount of Electrical Power the Device
Draws from the Battery Pack Based, at
Least in Part, on the Data Indicative of
the Impedance of the Battery Pack

704

Control, by the Controller, Operation of
the Device Such that the Device Draws
the Adjusted Amount of Electrical Power
from the Battery Pack

706

FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017160346 A
- WO 2020079474 A
- US 2019312242 A
- US 10283987 B